Europäisches Patentamt

European Patent Office

Office européen des brevets

(11) Publication number: **0 350 305**
**A2**

# (12) EUROPEAN PATENT APPLICATION

(21) Application number: **89306868.4**

(22) Date of filing: **06.07.89**

(51) Int. Cl.5: **C 30 B 15/04**
**C 30 B 29/06**

(30) Priority: **07.07.88 JP 167779/88**
**20.09.88 JP 235793/88**

(43) Date of publication of application:
**10.01.90  Bulletin  90/02**

(84) Designated Contracting States: **DE FR GB IT NL**

(71) Applicant: **NKK CORPORATION**
**1-2, Marunouchi 1-chome Chiyoda-ku**
**Tokyo 100  (JP)**

(72) Inventor: **Kamio, Hiroshi**
**3-8-4, Koyama**
**Nerima-ku Tokyo  (JP)**

**Shima, Yoshinobu**
**5-12-1-205 Shimosueyoshi Tsurumi-ku**
**Yokohama-shi Kanagawa-ken  (JP)**

**Kazama, Akira**
**2-3-3-206 Miyamaedaira Miyamae-ku**
**Kawasaki-shi Kanagawa-ken  (JP)**

(74) Representative: **Marsh, Roy David et al**
**Urquhart-Dykes & Lord 419B Midsummer House**
**Midsummer Boulevard**
**Central Milton Keynes MK9 3BN  (GB)**

(54) Method and apparatus for manufacturing silicon single crystals.

(57)  A silicon single crystal manufacturing method and apparatus capable of feeding a dopant quantitatively and stably. The dopant concentration of the molten silicon is estimated by reference to the weight of the growing silicon single crystal or the weight of silicon starting material fed to the apparatus, in order predictively to compute the time and amount of addition of dopant (10). Dopant in the form of unit dopant chips are continuously or intermittently fed by a dopant feeder (9) including a cylinder (91), a piston (92) and a piston actuator (93).

F I G. I

**Description**

# METHOD AND APPARATUS FOR MANUFACTURING SILICON SINGLE CRYSTALS

## BACKGROUND OF THE INVENTION

### Field of the Invention

The present invention relates to a method of manufacturing silicon single crystals by the Czochralski method (hereinafter referred to as a CZ method) and more particularly to a method of adjusting the concentration of a dopant.

### Description of the Prior Art

The manufacturing method of batch-type silicon single crystals by the CZ method has heretofore been in use and it has become a substantially complete technique. In the manufacture of such batch-type silicon single crystals, however, the amount of the melt in a crucible is decreased as a silicon single crystal is pulled and grown and the segregation coefficient of a dopant is smaller than 1, with the result that the concentration of the dopant in the remaining melt is increased and the concentration of the dopant taken into the silicon single crystal is gradually increased in its longitudinal direction. Thus, there has been a problem that the quality in the longitudinal direction of the produced silicon single crystal varies. In other words, due to the segregation of the dopant, the electric resistivity of the silicon single crystal is gradually decreased according to the lapse of the time of solidification. Thus, in the case of C-MOS ICs, for example, the yield of silicon wafers has been less than about 40%.

As a means of solving this problem, there has been formerly known the idea of continuously or intermittently feeding a silicon starting material and a dopant and melting them, thereby maintaining constant the dopant concentration in the longitudinal direction of a silicon single crystal. In Japanese Laid-Open Patent No. 58-130195, there is shown an apparatus which produces a silicon single crystal while continuously feeding a silicon starting material and a dopant into a crucible. According to this invention, there is used a quartz crucible of the double structure in which the inner crucible is formed with a slit-like hole and a silicon starting material feed pipe and a dopant feed pipe are inserted into the quartz crucible between the inner and outer crucibles so as to be immersed into molten silicon, thereby continuously feeding a silicon starting material and a dopant as a silicon single crystal is pulled.

On the other hand, the inventions of Japanese Laid-Open Patents No. 61-132585 and No. 61-163188 disclose examples of dopant feeding apparatus. The apparatus of the former invention is designed so that a predetermined weight of a dopant is preliminarily set in a dopant charging unit arranged above a heating furnace and the dopant is charged after the silicon starting material in a crucible has been melted.

In the apparatus of the latter invention, a silicon rod doped to a high concentration is arranged within a heating furnace thereby forming an electric loop comprising the silicon rod, molten silicon, a silicon single crystal, a power source and the silicon rod. Then, while detecting the contact between the silicon rod and the surface of the molten silicon by the electric loop, the silicon rod is immersed into the molten silicon, thereby adjusting the dopant concentration of the molten silicon.

However, the invention of Japanese laid-Open Patent No. 58-130195 has disadvantages which may be summarized as follows:

(1) The silicon starting material and the dopant are fed to the melt outside of the inner crucible so that although the convection of the melt in the inner crucible is not disturbed much, the melts on the inner and outer sides always go in and out through the relatively large slit-like holes formed through the inner crucible and the temperature of the melt on the inner side of the inner crucible attains the same melt temperature as the high-temperature melt on the outer side of the inner crucible. As a result, stabilized growth of the silicon single crystal is impeded. Also, the dopant concentration becomes the same in the melt between the inner and outer sides of the inner crucible, thus increasing the dopant variation in the longitudinal direction of the silicon single crystal as the supply of the dopant becomes increasingly intermittent. In order to prevent this, the dopant must be fed continuously in such a manner that the dopant concentration of the melt in the crucible is maintained constant. To do so requires a large quantity of a dopant of a considerably low concentration and the production of such dopant is not practical.

(2) Since the outlet of the dopant feed pipe is immersed in the melt in the outer side of the inner crucible, the supplied dopant is melted and stored temporarily in that portion of the feed pipe which is immersed in the melt. While there will be no problem if the molten dopant flows out into the melt on the outside of the inner crucible from the feed pipe outlet in an amount corresponding to the amount of the dopant fed, there is a disadvantage that if there is caused a phenomena in which the molten dopant in the feed pipe is replaced with the melt on the outer side due to a heat convection, forced convection or the like, the uniformity of the dopant concentration of the silicon single crystal is impeded.

Due to these reasons, the apparatus of this invention has not been put in practical use as yet.

In accordance with the invention disclosed in Japanese Laid-Open Patent No. 61-132585, it is possible to charge the dopant for only once. However, in an apparatus of the type in which a silicon single crystal is grown while feeding the silicon starting material continuously, it is difficult to charge the dopant periodically and quantitatively.

On the other hand, the invention disclosed in Japanese laid-Open Patent No. 61-163188 is so designed that when a silicon rod is melted by immersing it in molten silicon, ripples are caused in the surface of the molten silicon with the resulting disadvantage of causing variations in the melting rate of the silicon rod. While it is conceivable to decrease the dopant concentration of the silicon rod and increase its amount of immersion for the purpose of decreasing such variations of the molten quantity, when applied to the above-mentioned apparatus, a considerable amount of the silicon rod must be melted continuously thus giving rise to a number of technically difficult problems such as the loading of a silicon rod, anticipated solidification of the molten silicon at the surface of the melt and so on.

SUMMARY OF THE INVENTION

(1) The present invention has been made in view of the foregoing circumstances and it is an object of the invention to provide a method and apparatus of pulling a silicon single crystal while continuously charging a starting material and capable of positively melting the silicon starting material without impeding the growing of the single crystal, thereby ensuring the manufacture of the silicon single crystal having substantially the constant dopant concentration in the pull direction.

The silicon single crystal manufacturing method of this invention features that in the CZ method for producing a silicon single crystal while continuously feeding a silicon starting material and a dopant, a buffer wall is arranged within a crucible for holding molten silicon that said silicon is divided by the buffer wall into a central section forming a silicon crystal growing region and a peripheral section forming a region into which the silicon starting material and the dopant are fed, and that the silicon starting material and the dopant are fed onto the melt surface in the central section and the molten silicon is allowed to flow in one direction from the peripheral section into the central section via the small holes formed in the buffer wall whereby in accordance with the weight of a growing silicon single crystal or the weight of the silicon starting material fed, the molten dopant concentration of the melt in the central section is estimated and the time and amount of addition of the dopant to the melt in the peripheral section are predicted thus repeatedly adding the dopant, thus maintaining the dopant concentration of the inside melt within a predetermined range.

In accordance with the another feature, the range of variations of the resistivity in the longitudinal direction of a grown silicon single crystal is less than 1%, and moreover the range of variations of the oxygen concentration in the longitudinal direction of the silicon single crystal is less than 3%.

In accordance with still another feature, the initial dopant concentration of the molten silicon in the crucible is held lower than the desired concentration of a silicon single crystal.

In accordance with still another feature, the dopant used comprises a circular disk of silicon wafer or wafer-like material having a known dopant concentration and cut to a fixed shape.

(2) On the other hand, the silicon single crystal manufacturing apparatus of this invention features that in the CZ method of growing a silicon single crystal while continuously feeding a silicon starting material and a dopant, the apparatus comprises a crucible containing molten silicon, a buffer wall arranged to divide the molten silicon in the crucible into a central section containing a silicon single crystal and a peripheral section on the outer side of the central section and formed with small holes in its lower part, a computer for simulating the change and future of the dopant concentration in the melt, a silicon single crystal pull mechanism for measuring the pulled weight of the silicon single crystal to send a pulled weight indicative signal to the computer, a silicon starting material feeder for deeding the silicon starting material onto the surface of the melt in the crucible peripheral section and measuring the amount of the material fed to send a corresponding signal to the computer and a dopant feeder responsive to a command frog the computer to feed the dopant to the crucible peripheral section. The dopant feeder features that it includes a cylinder having an open end, containing a charge consisting of a plurality of dopant chips having the same concentration and weight and very high quantitativeness and obliquely arranged on the outer side of a heating furnace with the open end at the top, a cylinder piston and a piston actuator, and a charging pipe arranged in a manner that its one end is disposed near to the cylinder open end and its other end is disposed near to the surface of the molten silicon on the outer side of the buffer wall in the crucible.

Since the interior of the crucible is divided by the buffer wall such that the dopant is fed onto the surface of the melt on the outer side of the wall to rapidly melt and diffuse the dopant by utilizing the whole melt on the outer side of the buffer wall and since the melt including the dopant fed is moved in one direction from the outer side to the inner side of the wall only through the small holes formed therethrough in an amount corresponding to the amount of a silicon single crystal being grown, the variation in the dopant concentration of the melt on the inner side of the buffer wall is considerably relieved due to the previous dilution on the outer side of the buffer wall. Also, since the time, and amount of addition of the dopant are predicted while computing estimating the dopant concentration of the melt inside of the buffer wall in accordance with the weight of the grown silicon single crystal and the amounts of the silicon starting material fed and the dopant fed thereby maintaining the dopant concentration of the inside melt within a predetermined range, it is possible to respond fully accurately to the variations in the diameter of the silicon single crystal and the variations in the rate of pull from the initial condition up to the steady-state condition thus decreasing the variations of the dopant concentration in the longitudinal direction of the silicon single crystal and thereby producing the high-quality silicon single crystal.

Since the initial concentration of the dopant in the molten silicon in the crucible is selected lower than the desired concentration of a silicon single crystal to be grown the steady-state concentration can be attained in a shorter period of time.

In the dopant feeder, the piston is advanced a given stroke by the actuator so that one or more of the dopant chips prepared by precision cutting a circular disk of silicon wafer or wafer like material and having an extremely high quantitativeness are forced out from the cylinder and are doped into the molten silicon through the charging pipe. The charging of dopant chips is terminated by stopping the piston.

By thus using the dopant in the forms of chips of silicon wafer or wafer-like material, the crystal resistivity, i.e., the dopant concentration and the dopant weight can be grasped accurately and also the quantitativeness can be improved extremely.

BRIEF DESCRIPTION OF THE DRAWINGS

Fig. 1 is a longitudinal sectional view of a silicon single crystal manufacturing apparatus according to an embodiment of the present invention.

Figs. 2A to 2E are graphs useful for explaining the effects of the dopant buffer wall.

Fig. 3 is a graph showing the changes with time of the molten silicon concentration in the central and peripheral sections of the crucible.

Fig. 4 is a graph showing variations in the crystal resistivity in the longitudinal direction of a silicon single crystal.

Figs. 5A and 5B are diagrams showing the melt concentrations in the crucible.

Fig. 6 is a graph showing variations in the crystal resistivity when the initial concentration of the melt is decreased.

Figs. 7A and 7B show respectively the crystal resistivity distributions in the longitudinal directions of the crystals according to the embodiment and the conventional method.

Fig. 8 is a schematic diagram showing the construction of the dopant feeder.

DESCRIPTION OF THE PREFERRED EMBODIMENTS

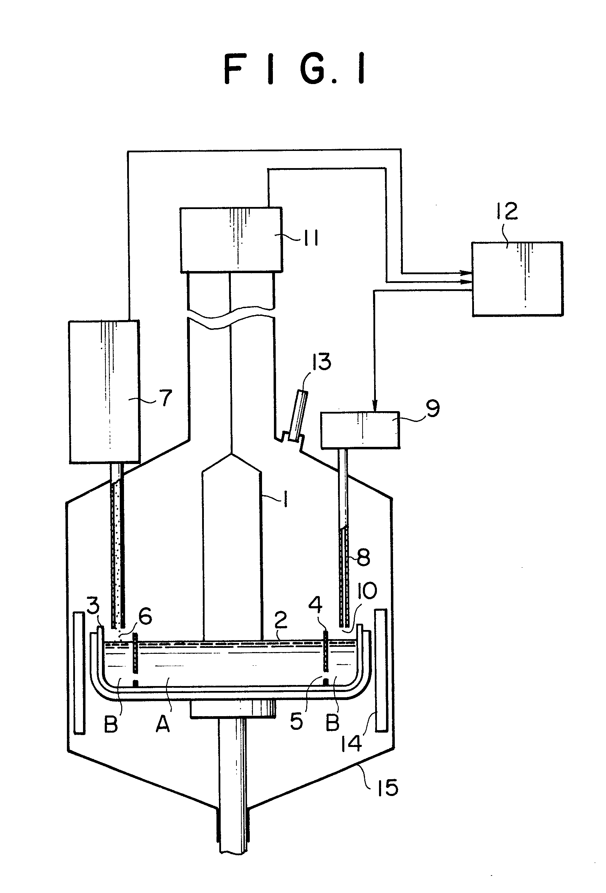

An embodiment of the present invention will be described in detail with reference to the accompanying drawings. Fig. 1 is a longitudinal sectional view of a silicon single crystal manufacturing apparatus according to the embodiment of the present invention.

In the Figure, numeral 1 designates a silicon single crystal, 3 a quartz crucible for containing molten silicon 2, and 4 a quartz buffer wall for dividing the melt in the crucible 3 into the inside and outside portions. The buffer wall 4 is arranged to surround the silicon single crystal 1 and it is formed with small holes in its lower part. Numeral 6 designates a granular silicon starting material which is fed onto the surface of the melt outside of the buffer wall 4 by a silicon starting material feeder 7. Numeral 10 designates a dopant which is fed onto the melt surface outside of the buffer wall 4 by means of a dopant feed pipe 8 and a dopant feeder 9 Numeral 11 designates a silicon single crystal pull mechanism serving a function of pulling and rotating the silicon single crystal 1 and measuring its weight. Numeral 12 designates a computer for receiving the signals from the silicon starting material feeder 7, the dopant feeder 9 and the single crystal pull mechanism 11 to make computations during the pulling of the single crystal to control the charging of the dopant. Numeral 13 designates a thermometer for measuring the temperature of molten silicon, 14 a heater for heating the crucible 3, and 15 a chamber.

With the construction described above, the operation of the silicon single crystal manufacturing apparatus will now be described. This apparatus is applied to the method of continuously growing a silicon single crystal while continuously feeding a silicon starting material.

The molten silicon or melt 2 is divided into a central section A including the silicon single crystal and an outer peripheral section B by the buffer wall 4 arranged within the crucible 3. The silicon starting material 6 and the dopant 10 are respectively fed by the silicon starting material feeder 7 and the dopant feeder 9 onto the surface of the melt in the peripheral section B in the corresponding amounts to the growth rate of the silicon single crystal 1. The silicon starting material 6 and the dopant 10 fed in this way are melted by the melt in the peripheral section B heated to a high temperature oy the heater 14 arranged along the side of the crucible 3 so that the melt flows in one direction to the central section A through the small holes 5 formed in the buffer wall 4 and the surfaces of the two melts are always held on the same level. It is to be noted that in the present embodiment the diameter and number of the small holes 5 are respectively 5mm and 2, and the thickness of the buffer wall 4 is 8mm.

The silicon starting material feeder 7 and the dopant feeder 9 respectively feed the silicon starting material 6 and the dopant 10 onto the surface of the melt in the peripheral section B of the crucible 3. While, in this embodiment, the dopant is charged through the path different from that of the silicon starting material as shown in Fig. 1, they may be charged through the same path.

In accordance with the former method, however, the high-purity silicon starting material and the dopant are melted at substantially the same position and this has the effect of reducing the dopant concentration segregation in the melt of the peripheral section B.

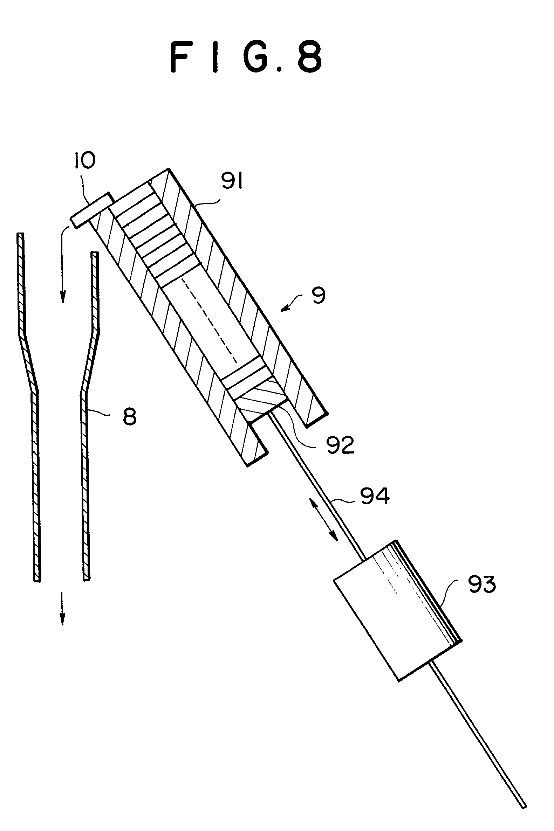

Referring now to Fig. 8, there is illustrated a schematic diagram showing an embodiment of the dopant feeder 9. In the dopant feeder 9 of the invention, numeral 91 designates a cylinder arranged obliquely and having an open forward end, 92 a piston, and 93 an actuator for the piston 92 made of, e.g. a solenoid or the like connected to the piston 92 through a rod 94.

The dopant charging pipe 8 is arranged so that is one end is adjacent to the open end of the cylinder 9 and its other end is adjacent to the surface of the molten silicon. The dopant chips 10 are loaded into the cylinder 91 and the chips are the same in shape, weight and concentration.

These chips are prepared by using as a raw material a wafer and a wafer-like circular disk cut from a single-crystal silicon rod and therefore the resistivity and thickness are known highly accurately. The disk is cut into square chips with a dicer used during the device fabrication process and therefore these chips can be formed to a regular shape with a high degree of accuracy.

The cylinder 91 and the charging pipe 8 are each made of a material which is low in friction with the dopant chips 10 and has no danger of producing any undesired impurity (e.g., the cylinder is made of a pure polycrystal silicon and the charging pipe is made of quartz glass).

With the construction described above, the operation of the dopant feeder 9 will now be described. In the first place, the piston 92 is moved backward and dopant chips 10 are loaded into the cylinder 91. In order to charge the dopant chips 10, the actuator 93 is operated to gradually move the piston 92 forward. When this occurs, the whole dopant chips 10 are forced upward so that the foremost dopant chip 10 is forced to drop from the cylinder 91 and fall into the crucible 3 through the charging pipe 8. It is to be noted that the shape of the dopant chips 10, the angle of inclination of the cylinder 91, etc., are adjusted so as to allow the dopant chips 10 to fall one by one.

When the required number of the dopant chips have been charged, the forward movement of the piston 92 is stopped or it is moved backward slightly thereby stopping the charging. These forward and backward strokes, operation time, etc., of the piston 92 are controlled by feed rate control means(not shown).

The feeding of the dopant is performed in such a manner the computer 12 receives the signals from the silicon material feeder 7 and the single crystal pull mechanism 11 so that the desired feed rate and feed time of the dopant are successively computed and the resulting signal is applied to the dopant feeder 9 which in turn feeds the dopant through the dopant feed pipe 8.

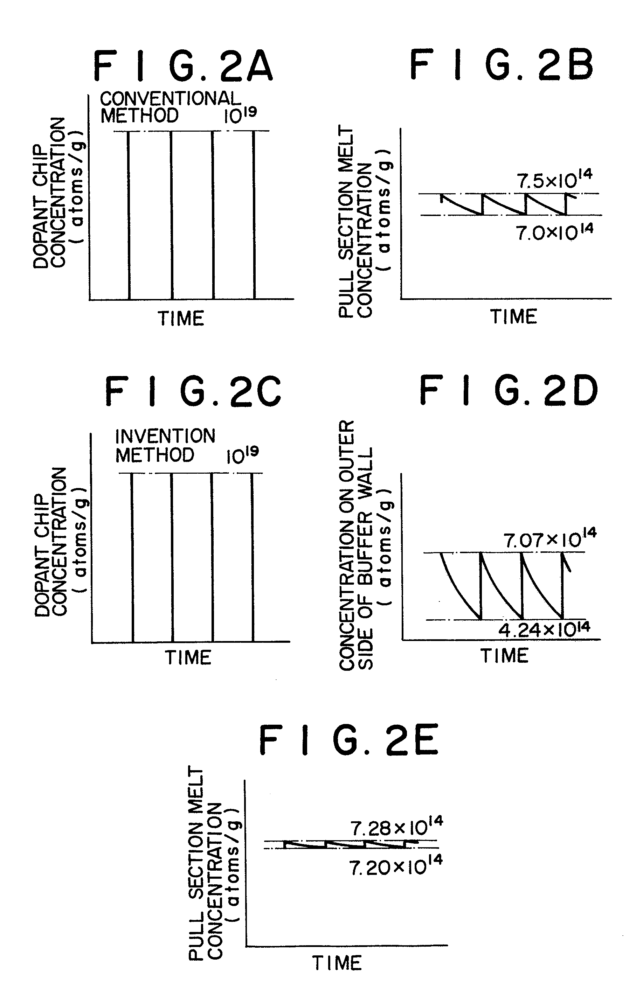

Next, the buffer wall 4 will be explained. Figs. 2A to 2E are graphs showing the results of a comparison of the dopant buffer walls, that is, a comparison between the cases where use is made of the conventional wall of the type which allows the inside and outside melts to mix and where use is made of the dopant buffer wall of the invention which makes very difficult the mixing of the melts on the inner and outer sides of the wall.

Where the dopant chips having a concentration of $10^{19}$ atom/g are fed by a given amount at intervals of a given time onto the surface of a melt (Figs. 2A and 2C), the buffer wall of the conventional type allows the melts on the inner and outer sides of the wall to mix easily so that the dopant concentration of the melt in the silicon single crystal pull section is substantially the same with that of the melt present on the outer side of the wall and fed with the dopant chips. Thus, it varies as large as $7.0 \times 10^{14} \sim 7.5 \times 10^{14}$ atom/g as shown in Fig. 2B. The range of the variations is about 7%. On the other hand, where there is almost not mixing of the melts on the inner and outer sides of the wall as in the case of the present invention, while the dopant concentration of the melt on the outer side of the buffer wall varies as much as $4.24 \times 10^{14} \sim 7.07 \times 10^{14}$ atom/g as shown in Fig. 2D, the dopant concentration of the melt in the silicon single crystal pull section varies as small as $7.20 \times 10^{14} \sim 7.28 \times 10^{14}$ atom/g as shown in Fig. 2E. This variation range is about 1%. This is due to the fact that the dopant chips of a high concentration are first diluted by the melt on the outer side of the buffer wall and the diluted melt is moved gradually into the silicon single crystal growth section through the small holes, and the diluted melt moving through the small holes corresponds to a case where as if low-concentration dopant chips are fed considerably continuously as in the case of the conventional type. Note that in the case of the conventional type, if it is desired to control the dopant concentration variation of the silicon single crystal growth section to about the same amount as the present embodiment, dopant chips of a very low concentration must be fed considerably continuously.

It is not realistic to prepare a large amount of such dopant chips of a very low concentration.

The method of adjusting the dopant concentration of a silicon single crystal will now be described.

A simulation model relating to the silicon single crystal manufacturing apparatus shown in Fig. 1 is prepared by the computer 12. During the initial period of the operation, the total amount of the molten silicon and the ratio between the amounts of the melts in the central section A and the peripheral section B are inputted to the simulation model. During the operation, the computer 12 always takes in the actual amount of the pulled crystal, the actual amount of the silicon starting material fed and the actual amount of the dopant added so that in accordance with these amounts, the current concentration of the melt in the crystal pull region (the central section A) and future melt concentration variations are predicted according to the simulation model. In addition, the optimum amount and time of the next dopant addition are determined so that after the second addition the same operation as mentioned previously is repeated. By repeating the foregoing operation 1 to 5 times since the beginning of the operation, the operation comes into a steady-state condition. What is meant by the steady-state condition is that with a crystal being pulled with a fixed diameter and a constant rate, the continuous feeding of the silicon starting material and the addition of the dopant cause the average concentration of the peripheral section B to become the same as the dopant concentration Cs of the crystal and the concentration of the central section A is stabilized at 1/K times (K is the average partition coefficient of the dopant; for example, K = 0.8 in the case of boron) the value of Cs. It is to be noted that the foregoing operation necessarily involves the effect of ensuring the coincidence of the accounts of the weight of the grown crystal and the dopant required for maintaining the desired resistivity.

In this connection, the pulling of the single crystal and the feeding of the silicon starting material are controlled by other algorithms different from that of the present invention and thus the computer 12 only receives the results as its inputs.

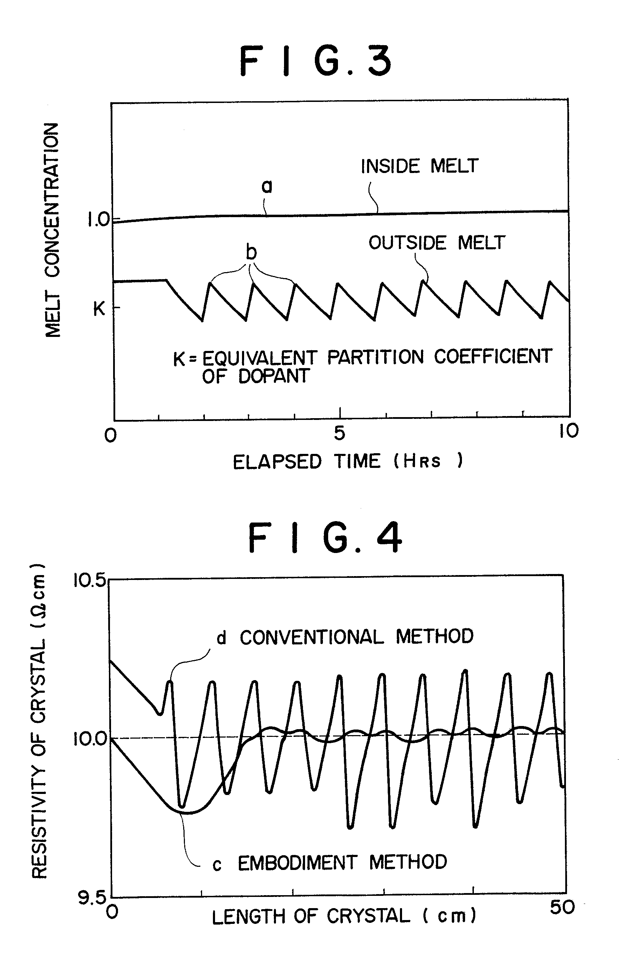

Immediately after the charging of the dopant 10, the dopant concentration of the molten silicon 2 in the peripheral section B is increased and then the dopant concentration is decreased with time. This is repeated each time the dopant is charged. This situation is shown by the graph b of Fig. 3. Since the molten silicon of the peripheral section B flows in one direction via the small holes 5 formed in the dopant buffer wall 4 into the central section A, practically there is no variation in the concentration of the melt in the central section A as shown by the graph a of Fig. 3.

Fig. 4 is a comparison between the crystal resistivity distributions of the conventional method and the present embodiment. There is a relation that the lower the crystal concentration is, the higher the resistivity of the crystal is. In Fig. 4, the graph c shows the present embodiment and the graph d shows the conventional method and these graphs respectively correspond to the presence and absence of the buffer wall. The effect of the buffer wall will be clearly understood from a comparison in steady-state crystal resistivity variation between the two methods according to Fig. 4.

Next, a description will be made of the variations of the dopant concentration under non-steady-state condition from the seeding at the beginning of the growth of the silicon single crystal 1 until reaching a steady-state condition. During the initial period of the operation, the melts of the central section A and the peripheral section B have the same concentration due to their diffusion and mixing through the small holes of the buffer wall so that if the ordinary value of the CZ method is employed as the initial melt concentration, the dopant concentration of the crystal is increased excessively thus requiring a considerable time before reaching the steady-state condition.

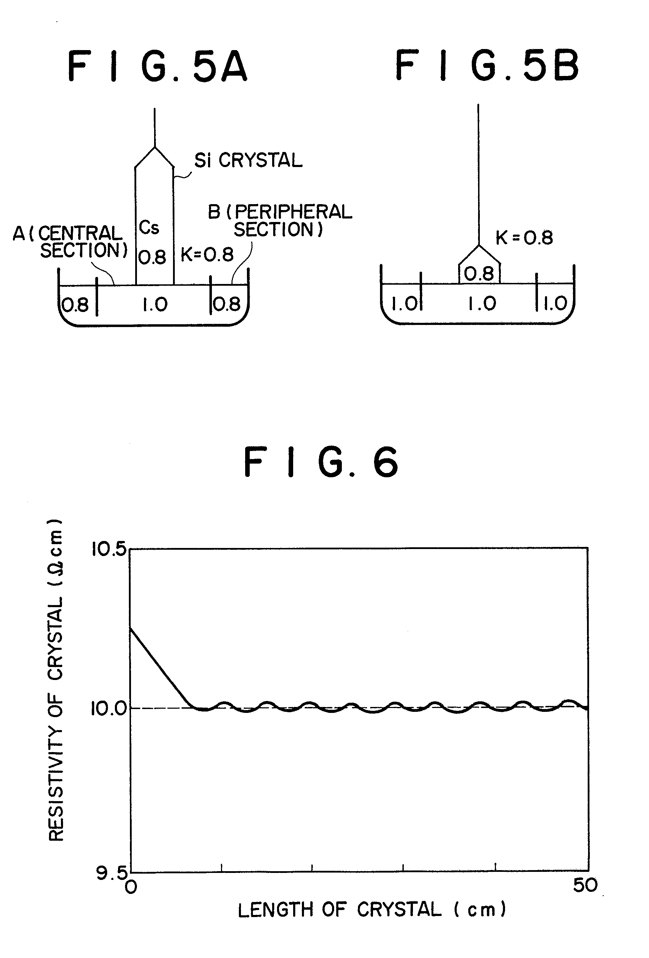

This phenomenon will be described with reference to Figs. 5A and 5B showing the melt concentrations in the crucible.

Fig. 5A shows the concentrations of the various portions in the steady-state condition, and Fig. 5B shows the concentrations of the various portions during the initial condition. For purposes of simplicity, the melt concentration of the central section A is represented as 1.0 and the concentrations of the various portions are represented by relative values. The segregation coefficient K of the dopant is represented as 0.8 by way of example. In the steady-state condition of the continuous pull, the concentration of the peripheral section B is equal to the silicon crystal concentration, that is, it is reduced by K times as compared with the central section A (see Fig.5A). On the other hand, during the initial period the central section A and the peripheral section B are the same in concentration (see Fig. 5B). As a result, during the initial period the amount of the dopant in the melt on the whole is excessive in correspondence to the amount by which the concentration of the peripheral section B is greater than the concentration in the steady-state condition. Therefore, if the concentration of the central section at the beginning of the operation is set to the ordinary value (the relative value of 1.0), a silicon single crystal is pulled through a region of an excessively increased concentration before reaching a steady-state condition and this results in a waste portion at the head of the crystal (see Fig.4).

Thus, by setting the initial concentration to a relatively low value, the concentration of the central section A can be prevented from becoming excessively high and the time required for reaching the steady-state condition is decreased.

The present embodiment shows that by setting the initial concentration lower than that of the CZ method, a steady-state condition can be reached earlier. Fig. 6 and the graph c of Fig. 4 show the resistivity variations under the same conditions with only the initial concentrations being different. In other words, the initial melt concentration of the former is set lower than that of the latter by 2.5% and the initial concentration of the latter is set as in the case of the ordinary CZ method. From a comparison between the Figures it will be seen that the latter requires a longer time for reaching the steady-state condition. While, in the present embodiment, silicon wafer chips are used as the dopant, this dopant is quite excellent in quantitativeness since the dopant content can be determined accurately by measuring the resistivity and weight of the wafer chip. By suitably selecting the amount of the silicon wafer chips for each charge, the chips are melted rapidly upon charging into the peripheral section of the crucible 3.

The specific numerical values involved in the present embodiment are as follows. The silicon single crystal 1 has a diameter of 150mm and a desired resistivity of $10\Omega$ cm and its pull rate is about $0.5 \sim 1$mm/min. The silicon starting material 6 is composed of pure granular silicon of $0.5 \sim 3$mm in diameter. The dopant 10 comprises silicon wafer chips having a square shape of 5mm, a thickness of $525 \mu$m and a resistivity of $0.01 \Omega$ cm and 7 to 8 chips are charged every time at intervals of 20 to 40 minutes in the steady-state condition with the crystal pull rate of 1mm/min. With the thus produced silicon single crystal, the range of variations of the resistivity in the longitudinal direction of its steady-state portion has been fully controlled to less than 1% of the desired value. Also the range of variations of the oxygen concentration is fully controlled to less than 3%, thus making it possible to manufacture silicon single crystals of high quality as compared with the conventional method.

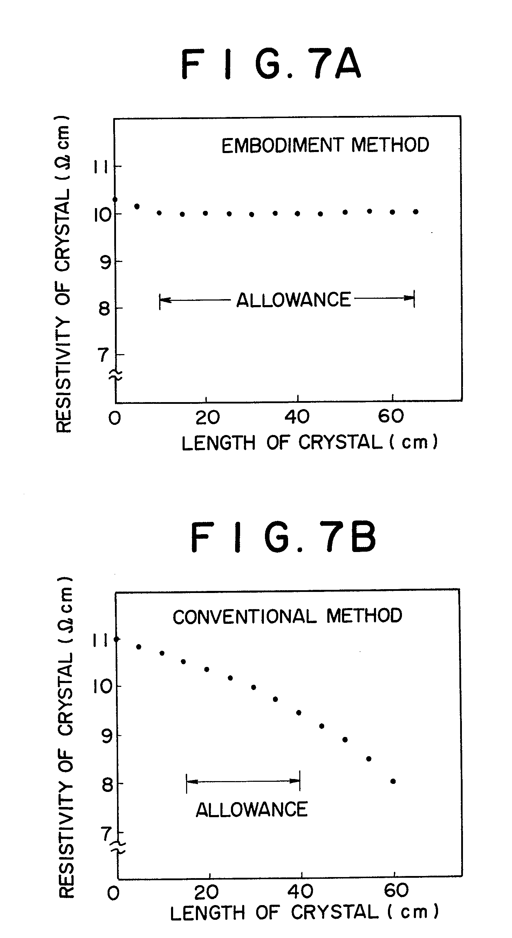

Figs. 7A and 7B show respectively the resistivity distributions along the longitudinal directions of the crystals according to the present embodiment and the conventional method. As will be seen from the Figures, the yield as the product satisfying the allowable resistivity can be increased very greatly. Here, the allowance is about 10 $\Omega$ cm for the crystal resistivity.

In accordance with the present invention, by virtue of the fact that a buffer wall is arranged within a crucible and that during the growth of a silicon single crystal the feed rate and time of a dopant are determined in accordance with the feed rate of a silicon starting material and the weight of the silicon single crystal grown by a simulation computation thereby feeding the dopant chips of the chips of the same concentration and weight onto the surface of the melt on the outer side of the concentration buffer wall, there is the effect of producing a silicon single crystal which is extremely excellent in quantitativeness, has no danger of impeding the growing of the single crystal, ensures the constant dopant concentration and has the uniform resistivity along the growing direction, thereby increasing the yield of the silicon single crystal on the whole with respect to the desired resistivity.

## Claims

1. A silicon single crystal manufacturing method for growing a silicon single crystal while continuously feeding a silicon starting material and a dopant according to the Czochralski method, said method comprising the steps of:
arranging a buffer wall within a crucible containing molten silicon so as to divide said molten silicon into a central section forming a single silicon crystal growing region and a peripheral section forming a region into which said silicon starting material and said dopant are fed;
feeding said silicon starting material and said dopant onto a surface of said molten silicon in said peripheral section;
flowing said molten silicon in one direction from said peripheral section into said central section through a plurality of small holes formed through said buffer wall; and
estimating a dopant concentration of said molten silicon is said central section in accordance with a weight of a growing silicon single crystal or a weight of said silicon starting material fed to predict a time and amount of addition of said dopant to said molten silicon in said peripheral section thereby repeatedly adding said dopant to maintain the dopant concentration of said molten silicon on an inner side of said buffer wall within a predetermined range.

2. A manufacturing method according to claim 1, wherein a range of variations in a resistivity of said grown silicon single crystal along a longitudinal direction thereof is 1% or less, and wherein a range of variations in an oxygen concentration of said silicon single crystal along the longitudinal direction thereof is 3% or less.

3. A manufacturing method according to claim 1, wherein an initial dopant concentration of said molten silicon in said crucible is predetermined lower than a desired concentration of said silicon single crystal.

4. A dopant prepared by cutting to a fixed shape a circular disk of silicon wafer or wafer-like material of a known dopant concentration.

5. A silicon single crystal manufacturing apparatus for growing a silicon single crystal while continuously feeding a silicon starting material and a dopant according to the Czochralski method, said apparatus comprising:
a crucible containing molten silicon;
a buffer wall arranged to divide the molten silicon in said crucible into a central section containing said silicon single crystal and a peripheral section on an outer side of said central section, said buffer wall being formed with a plurality of small holes in a lower part thereof;
a computer for simulating a change and future of said molten silicon concentration;
a silicon single crystal pull mechanism for measuring a pulled weight of said silicon single crystal to send a pulled weight indicative signal to said computer;
a silicon starting material feeder for feeding said silicon starting material onto a surface of the molten silicon in said crucible peripheral section and measuring a feed rate thereof to send a feed rate indicative signal to said computer; and
a dopant feeder responsive to a command from said computer to feed said dopant to said crucible peripheral section.

6. A silicon single crystal manufacturing apparatus, wherein a dopant feeder comprises a cylinder opened at one end thereof, having a plurality of dopant chips loaded thereinto and arranged on an outer side of a heating furnace with said open end at a top thereof, a piston in said cylinder, an actuator for moving said piston, and a charging pipe arranged in such a manner that one end thereof is positioned near to the open end of said cylinder and the other end thereof is positioned near to the surface of the molten silicon on the outer side of said buffer wall in said crucible.

7. A manufacturing apparatus according to claim 6, wherein said dopant chips are the dopant chips of claim 4.

# F I G. 1

# F I G. 2A

CONVENTIONAL METHOD        10^19

DOPANT CHIP CONCENTRATION ( atoms/g )

TIME

# F I G. 2B

PULL SECTION MELT CONCENTRATION ( atoms/g )

7.5×10^14

7.0×10^14

TIME

# F I G. 2C

INVENTION METHOD        10^19

DOPANT CHIP CONCENTRATION ( atoms/g )

TIME

# F I G. 2D

CONCENTRATION ON OUTER SIDE OF BUFFER WALL ( atoms/g )

7.07×10^14

4.24×10^14

TIME

# F I G. 2E

PULL SECTION MELT CONCENTRATION ( atoms/g )

7.28×10^14

7.20×10^14

TIME

EP 0 350 305 A2

# F I G. 3

MELT CONCENTRATION

INSIDE MELT

a

1.0

OUTSIDE MELT

b

K

K = EQUIVALENT PARTITION COEFFICIENT OF DOPANT

0    5    10

ELAPSED TIME (HRS)

# F I G. 4

RESISTIVITY OF CRYSTAL (Ωcm)

10.5

d CONVENTIONAL METHOD

10.0

c EMBODIMENT METHOD

9.5

0    LENGTH OF CRYSTAL (cm)    50

# F I G. 5A

# F I G. 5B

# F I G. 6

# F I G. 7A

EMBODIMENT METHOD

ALLOWANCE

RESISTIVITY OF CRYSTAL ($\Omega$ cm)

LENGTH OF CRYSTAL ( cm )

# F I G. 7B

CONVENTIONAL METHOD

ALLOWANCE

RESISTIVITY OF CRYSTAL ($\Omega$ cm)

LENGTH OF CRYSTAL ( cm )

# F I G. 8